# EUROPEAN PATENT APPLICATION

(11) **EP 2 757 594 A1**
(43) Date of publication of application: **23.07.2014**
(21) Application number: 13305056.7
(22) Date of filing: 18.01.2013
(51) Int. Cl.: H01L 31/052

(54) **Solar radiation collector**

(71) Applicant: Alcatel Lucent, 75007 Paris (FR)
(72) Inventor: Hernon, Domhnaill, DUBLIN, 15 (IE); Arney, Susanne, MURRAY HILL, NJ New Jersey 07974-0636 (US); Gentner, Jean-Louis, 91460 MARCOUSSIS (FR); McGarry, Liam, DUBLIN, 15 (IE); Grangeat, Christophe, 91620 NOZAY (FR)
(74) Representative: Shamsaei Far, Hassan

(57) **Abstract**

A solar radiation collector comprising a body having internal channels is disclosed. At least one internal channel has a light reflective surface configured for directing light through the interior of the channel such that an angle of entry of light in one end of the internal channel with respect to a predetermined plane is different from an angle of exit of the light at an other end with respect to the same predetermined plane.

## Description

The present invention relates to solar light collection techniques.

### BACKGROUND ART

Solar cells are widely used for collecting solar energy. One very common use of the solar cells is in solar panels. One of the key limiting factors in installing solar cells is the requirement of tracking the sun to maintain the solar panel efficiencies near their optimum.

### SUMMARY

Typically the efficiency of a solar cell reduces considerably when the incident angle to the sun decreases beyond a certain angle from the main surface plane of the solar cell.

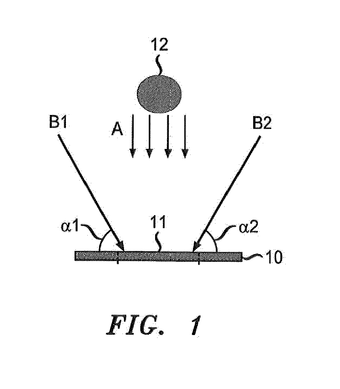

Herein, the term efficiency is meant to refer to the amount of energy a solar cell can usefully convert to electricity when exposed to the sun light. Likewise the term "main surface" is to be understood to refer to the surface of solar cell that is configured to receive a majority of the sun light incident thereupon. The main surface plane therefore is an imaginary plane that such main surface defines. Figure 1 shows an exemplary schematic representation of a solar cell arrangement.

In this figure, the solar cell 10 is shown in a position for receiving light from the sun 12. Typically when the incident light from the sun 12 is reaching the solar cell 10 at a substantially perpendicular angel relative to the main surface 11 of the solar cell 10 - as shown in figure 1 by the set of arrows A - the efficiency of the panel is at or about maximum. As the angle of incident light changes from perpendicular, the efficiency is typically reduced. In figure 1 angle α1 < 90° represents one situation in which the efficiency of the solar cell would drop considerably from the optimum amount and angle α2 < 90° represents another situation in which the efficiency of the solar cell would drop considerably from the optimum amount. It may therefore be concluded that the incident sun light is in a useful range as long as the angle of the incident light relative to the surface 11 of the solar cell is above a threshold value. Such threshold value may be determined according to factors such as the required desired efficiency of the solar cell or the latitude of the deployment. In figure 1, the useful range for the incident sun light is schematically shown as the range between arrows B1 and B2, i.e. range B1-B2. Therefore, incident light from the sun reaching the solar cell within the useful range B1-B2 is considered to be within acceptable to maximum efficiency levels. Outside the range B1-B2, the efficiency of the solar cell drops considerably which implies that beyond said range, typically one cannot generate enough energy from the solar cell.

In the context of the present disclosure the incident sun light on a solar cell is considered to reach the solar cell in the form of substantially parallel beams as schematically shown in the figure by parallel arrows A. This consideration is in accordance with the generally accepted concepts in physics and optics that sun beams reach the earth in substantially parallel direction. It is further to be noted that although a beam of light reaching the solar cell defines two angles with respect to the main surface of the solar cell, one being an acute angle (such as the acute angles α1 or α2 in figure 1), and the other angle being its so-called supplementary angle (being the obtuse angles adjacent respectively to α1 or α2 in figure 1), what is relevant for the purpose of understanding the present disclosure is the acute angle (less than 90°) from the two angles mentioned above.

In order to overcome the above-described problem, some known solutions use solar trackers installed with the solar cells. A solar tracker is a known device which is capable of rotating the solar cell at different angles to orient the surface of the solar cell toward the sun. However, use of solar trackers typically adds cost, complexity and weight to the overall system and often introduces future reliability issues as the extra moving parts in the rotating mechanism may wear out or fail. The use of solar trackers in certain developing countries implies substantial additional costs making their use in such countries still more unattractive.

Another known solution is based on the use of solar concentrators. A solar concentrator is typically made with a concave mirror, a highly polished curved surface or a converging lens. The rays of the sun light are first incident on the concentrator and are then focused at the focal point of the concentrator, or at the vicinity of said focal point depending on the angle of incident light. One drawback associated with the use of solar concentrators is their relatively very large size (with surface typically larger than about 1m²).

Another drawback associated with the use of solar concentrators is that, due to the high level of concentration, solar radiation often heats the solar cell up to undesired temperature levels such that additional cooling becomes required for the solar cell. This is because typically above 25°C cell efficiency is reduced causing performance degradation and at higher temperatures failure may occur. Some cooling solutions require liquid cooling owing to the large heating effect of the solar concentrator; however use of liquid cooling typically adds cost and complexity.

The present disclosure features a comparatively low cost, low weight structure which is capable of trapping (collecting) the incident light at various angles of incident sun light and focuses the incident light onto the solar cell thereby providing increased efficiencies.

Some embodiments of the disclosure feature a solar radiation collector comprising a body having internal channels, wherein at least one internal channel has a light reflective surface configured for directing light through the interior of the channel such that an angle of entry of light in one end of the internal channel with respect to a predetermined plane is different from an angle of exit of the light at an other end with respect to the same predetermined plane. According to some specific embodiments, the body of the solar radiation collector is made of plastic. The use of plastic is optional and may be preferable as printing plastic is typically inexpensive and provides great flexibility in design. According to some specific embodiments, the body of the solar radiation collector is printed with a reflective surface.

According to some specific embodiments, the solar radiation collector is configured to be installed on a solar cell such that sun light entering at a first angle with respect to a main surface of the solar cell reaches the surface of the solar cell at a second angle with respect to the main surface of the solar cell which is different from the first angle.

According to some specific embodiments, the at least one internal channel comprises an optical fiber, the optical fiber comprising a first dielectric material having a first refractive index and a second dielectric material having a second refractive index, the second refractive index being lower than the first refractive index, the optical fiber being configured for guiding light by internal reflection at an interface between the first dielectric material and the second dielectric material.

According to some specific embodiments, the optical fiber is comprised in an optical fiber bundle.

According to some specific embodiments, the solar radiation collector is configured to re-direct the light to a lens.

Some embodiments of the disclosure feature a solar panel assembly comprising a solar panel having a plurality of solar cells and the solar radiation collector as featured herein.

According to some specific embodiments, the solar panel assembly comprises a lens configured for concentrating light received from the solar radiation collector to the solar cell.

### BRIEF DESCRIPTION OF THE DRAWINGS

Figure 1, already discussed, is an exemplary schematic representation of a known solar cell arrangement.
Figure 2 shows an exemplary schematic representation of a solar radiation collector according to an embodiment of the disclosure.
Figure 3 is an exemplary schematic representation of a solar radiation collector assembled with a solar cell according to some embodiments of the disclosure.
Figures 4a and 4b show exemplary schematic representations of a solar radiation collector assembled with a solar cell and a lens wherein the lens is configured to direct the light collected to the solar cell in respective different directions according to some embodiments of the disclosure.

It is to be noted that the figures are provided for mere illustrative purposes and are not to be construed as limiting the claimed invention in any way. In particular the figures are not made to scale.

### DETAILED DESCRIPTION

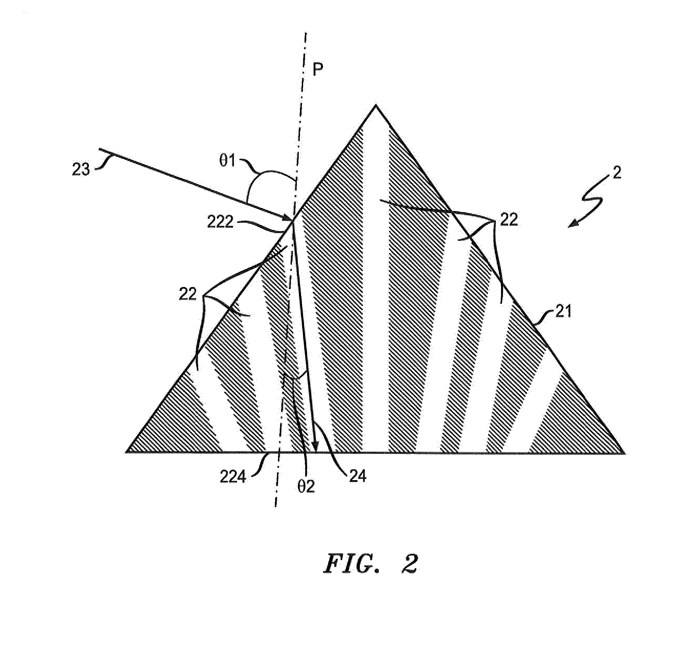

Reference is now made to figure 2 in which a solar radiation collector is schematically shown according to some embodiments. The solar radiation collector 2 comprises a body 21. The body 21 of the solar radiation collector may be made in any convenient shape. A three-dimensional body for the solar radiation collector has the advantage of providing the possibility of appropriately collecting the light incident from many different angles. Although figure 1 shows a triangular cross-section for the shape of the solar radiation collector 2, this is only exemplary and other shapes, for example rectangular, semicircular or polygonal cross-sections may also be used for the intended purpose.

The body 21 comprises internal channels 22. At least one internal channel 22 in body 21 has a light reflective surface configured for directing light through the interior of the channel. The channel 22 is preferably hollow inside having a first end 222 where the light from the sun is received and a second end 224 where the received light is output from the channel 22. However the use of hollow channels is optional and any other any medium through which light can propagate may be used.

Therefore, due to the reflective surface inside the channel 22, incident light entering the first end 222 is reflected - for example multiple times - and is directed toward the second end 224 where it is output from the channel 22. For example figure 2 shows light beam 23 which is incident on the body 21. For the sake of discussion an imaginary plane P is considered. As shown in the figure incident light beam 23 defines an angle θ1 with respect to the plane P. The light is subsequently directed toward the second end 224. Although the light may be reflected multiple times through the channel 22 as it propagates toward the second end 224, it may be clearly assumed that the light propagates in one general (overall) direction of propagation toward the second end 224, such general direction being the sum of individual directions (conceived as vectors) of light after the reflections. The general direction of propagation of light inside the internal channel 22 is shown by means of arrow 24. Arrow 24 therefore defines a second angle θ2 with the plane P. As can be observed from figure 2, angle θ1 is different from angle θ2. Therefore, channel 22 directs the incident light 23 such that the angle of entry of light θ1 at the first end 222 of the internal channel 22 is different from the angle of exit of the light θ2 at the second end 224.

Here again, similar to the discussion related to figure 1, it is noted that although two angles may be defined between the beam of light and the plane P, what is relevant for the purpose of understanding the present disclosure is the acute angles θ1 and θ2 (less than 90°) as shown in the figure.

Various channels 22 may be provided inside body 2 so as to capture the light incident from the sun at any desired angle corresponding to the latitude of the sun with respect to a solar panel. Although in figure 2, channels 22 are shown in non-parallel configuration with respect to each other, this is only exemplary and the channels 22 may adopt any convenient geometry with respect to each other according to the requirements of a specific design and within the scope of the claimed invention. For example, some or all of the channels may be provided in parallel direction with respect to each other while the condition of the angle of entry of light θ1 at the first end 222 of a channel 22 being different from the angle of exit of the light θ2 at the second end 224 of the channel is still fulfilled.

As mentioned above, instead of being hollow inside of a monolithic structure such as the one illustrated in figure 2, the internal channels may be made using other media for guiding the received sunlight to the solar cell. In some embodiments, an internal channel may comprise one or more optical fibers for guiding the light. In some embodiments, a bundle of optical fibers may be used as internal channels. In either embodiment, an optical fiber may comprise appropriately engineered refractive indices and/or physical structures to allow light to be guided through the individual fibers by reflection. The effect of reflection of light may be achieved by using an optical fiber (typically having a circular cross-section) comprising a first dielectric material having a first refractive index surrounded by a second dielectric material having a second refractive index which is lower than the refractive index of the first dielectric material. With such a structure of the optical fiber, light input in the first (inner) dielectric material may be confined in the first dielectric material by internal reflection at an interface between the two dielectric materials. Light may therefore be reflected multiple times at the interface layer between the first and the second dielectric materials as it propagates through the first dielectric material and thus be guided from an input of the optical fiber to an output thereof. Therefore, such interface between the two dielectric materials may be considered as a reflective surface for guiding the light through the optical fiber in a similar manner as described above in relation to figure 2.

In case a fiber bundle is used, it may have at one end a first composite surface, preferably polished and flat, comprising a plurality of first ends of individual fibers; and at another end a second composite surface, preferably polished and flat, comprising a plurality of second ends (opposite to the first ends) of individual fibers. The first composite surface may be located at a suitable position for receiving the sun light and the second composite surface may be located at a suitable position for outputting the received light.

Due to the guiding properties of optical fibers as described above, the intermediate portion of an individual fiber in-between the first surface and second surface may be shaped in any suitable way (e.g. curved) as long as such shaping does not compromise the propagation of light through the individual fiber. Such flexibility in shaping of the intermediate portion of the fiber is advantageous as it enables flexibility in the design of the overall apparatus.

The fibers as discussed above may be made of glass or plastic or any other suitable material.

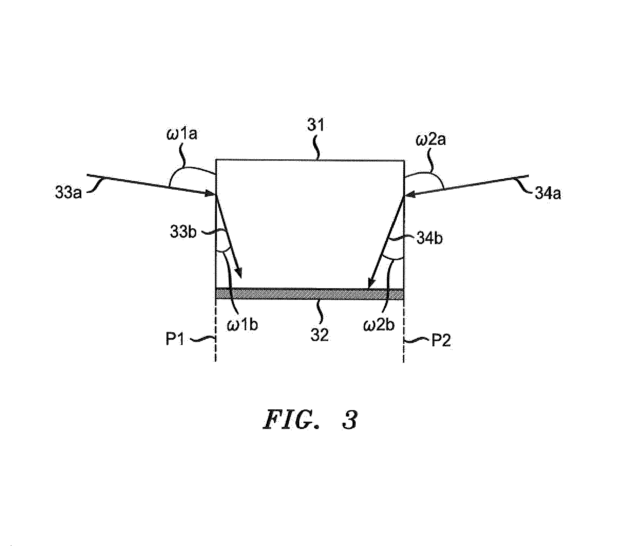

Figure 3 shows an exemplary schematic representation of a solar radiation collector 31 assembled with a solar cell 32. A plurality of solar cells 32 may be comprised in a solar panel (not shown). Similarly, a plurality of solar radiation collectors 31 may be comprised in a solar panel.

The solar radiation collector 31, in any convenient shape, is installed on the solar cell 32. Although for simplicity the description provided herein only refers to one solar cell and one solar radiation collector, the disclosure is not so limited. In practice, the solar radiation collector may be installed on a plurality of solar cells, e.g. on a solar panel and provide similar effects as described herein; likewise a plurality of solar radiation collectors may be coupled to a corresponding plurality of solar cells in a solar panel array.

Sunlight incident on the solar radiation collector 31 is represented by arrows 33a and 34a each representing a different angle of incidence. For example, light beam 33a is shown to define angle ω1ₐ with respect to the plane P1 corresponding to a side (or face) of the solar radiation collector 31, however other planes may be equally considered. The solar radiation collector 31 then directs the incident light toward the solar cell 32 at an angle ω1_{b} with respect to the plane P1 which is different from angle ω1ₐ as shown by arrow 33b.

Likewise light beam 34a represents the light incident from the sun on the solar radiation collector 31 at an angle ω2ₐ with respect to the plane P2 corresponding to a side (or face) of the solar radiation collector 31. The solar radiation collector 31 then directs the incident light toward the solar cell 32 at an angle ω2_{b} with respect to the plane P2 which is different from angle ω1ₐ as shown by arrow 34b. In this manner light incident from the sun at any angle may be directed to the solar cell at a different and therefore suitable angle such that the latter angle may provide a satisfactory level of efficiency in capturing the sun light within a useful range, for example as defined with respect to figure 1.

Optionally, a lens may be used for assisting in directing or focusing or concentrating the light received by the solar radiation collector to a solar cell (or solar panel).

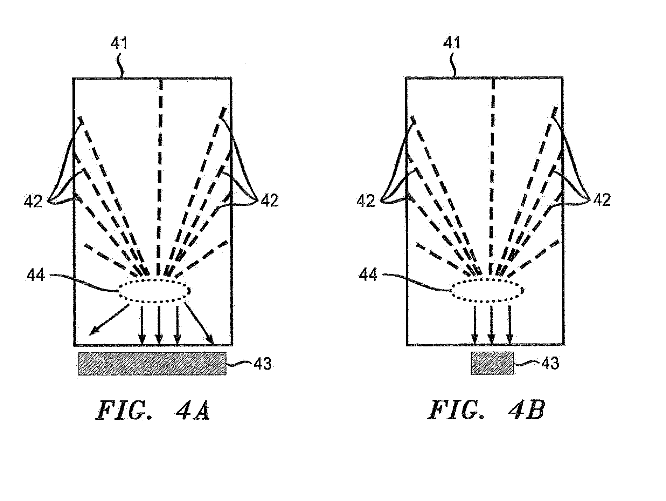

Figures 4a and 4b show exemplary schematic representations of a solar radiation collector assembled with a solar cell and a lens. In both figures 4a and 4b, solar radiation collector 41 comprises a plurality of internal channels as described with reference to figures 2 and 3. The solar radiation collector is installed on a solar cell 43 (or solar panel). According to this embodiment, a lens 44 is used to further direct the light received by the solar radiation collector 41 and propagated through internal channels 42 toward the solar cell 43. In the particular embodiment of figure 4a, the lens 44 is configured to spread (diverge) the received light across a specific larger area of the solar cell; whereas in the particular embodiment of figure 4b, the lens 44 is configured to generate a more compact (convergent) light to be directed to a specific smaller area of the solar cell.

In this manner a solar panel assembly may be provided comprising the solar radiation collector, solar cells and one or more lenses.

In all the embodiments herein, the angles and dimensions of the internal channels may be designed and optimized based on knowledge of the overall system design requirements.

The solar radiation collector may be made of any convenient material available in the market such as for example plastic, or in particular printed plastic due to the relatively high reflective capabilities of printed plastics. Although plastic is not the only material that can be used, it is considered one preferred material as it allows for printing complex geometries in a simple and quick way.

The solution proposed herein therefore provides the possibility of improving the generation of greater energy as solar radiation may be collected over a broad range of incident angles, while keeping the size of the overall device to a minimum as very large solar concentrators are not required

Furthermore, contrary to some conventional solutions, the proposed solar radiation collector may be designed in any shape or structure thereby providing the possibility of tailoring solutions for any application and any global position of the actual deployment.

Furthermore if the solar radiation collector is made by printing a body in plastic it will be lightweight, inexpensive and highly flexible in design.

The various embodiments of the present invention may be combined as long as such combination is compatible and/or complimentary.

Further it is to be noted that the list of structures corresponding to the claimed means is not exhaustive and that one skilled in the art understands that equivalent structures can be substituted for the recited structure without departing from the scope of the claimed invention.

It should be appreciated by those skilled in the art that any block diagrams herein represent conceptual views of illustrative elements embodying the principles of the invention.

## Claims

1. A solar radiation collector comprising a body having internal channels, wherein at least one internal channel has a light reflective surface configured for directing light through the interior of the channel such that an angle of entry of light in one end of the internal channel with respect to a predetermined plane is different from an angle of exit of the light at an other end with respect to the same predetermined plane.

2. The solar radiation collector of claim 1, wherein the body of the solar radiation collector is made of plastic.

3. The solar radiation collector of claim 1, wherein the body of the solar radiation collector is printed with a reflective surface.

4. The solar radiation collector of claim 1, wherein the solar radiation collector is configured to be installed on a solar cell such that sun light entering at a first angle with respect to a main surface of the solar cell reaches the surface of the solar cell at a second angle with respect to the main surface of the solar cell which is different from the first angle.

5. The solar radiation collector of claim 1, wherein the at least one internal channel comprises an optical fiber, the optical fiber comprising a first dielectric material having a first refractive index and a second dielectric material having a second refractive index, the second refractive index being lower than the first refractive index, the optical fiber being configured for guiding light by internal reflection at an interface between the first dielectric material and the second dielectric material.

6. The solar radiation collector of claim 5, wherein the optical fiber is comprised in an optical fiber bundle.

7. The solar radiation collector of any one of the previous claims, wherein the solar radiation collector is configured to direct the light to a lens.

8. A solar panel assembly comprising a solar panel having a plurality of solar cells and the solar radiation collector of any one of claims 1 to 7.

9. The solar panel assembly of claim 8 comprising a lens configured for concentrating light received from the solar radiation collector to the solar cell.
